# EUROPEAN PATENT APPLICATION

(11) **EP 4 518 608 A1**
(43) Date of publication of application: **05.03.2025**
(21) Application number: 24788035.4
(22) Date of filing: 08.04.2024
(51) Int. Cl.: H10B 12/00

(54) **SEMICONDUCTOR STRUCTURE AND MANUFACTURING METHOD THEREFOR**

(30) Priority: 14.04.2023 CN 202310420143
(71) Applicant: CXMT Corporation, Hefei City, Anhui Province 230601 (CN)
(72) Inventor: LIU, Xiang, Hefei, Anhui 230601 (CN)
(74) Representative: Gulde & Partner
(86) International application number: PCT/CN2024/086674
(87) International publication number: WO 2024/212932

(57) **Abstract**

A method for manufacturing a semiconductor structure includes: forming an initial structure, where the initial structure includes a plurality of main semiconductor pillars, each of the main semiconductor pillars includes a first sub-semiconductor pillar and a second sub-semiconductor pillar, a first isolation layer is provided between two adjacent main semiconductor pillars, a second isolation layer is provided between the first sub-semiconductor pillar and the second sub-semiconductor pillar, a first sacrificial pattern is provided on the first sub-semiconductor pillar and the second sub-semiconductor pillar, and the first sacrificial pattern is located between the first isolation layer and the second isolation layer; etching the first sacrificial pattern to expose the first sub-semiconductor pillar and the second sub-semiconductor pillar, where an etching rate of an etching material on the first sacrificial pattern is greater than an etching rate of the etching material on the first isolation layer and the second isolation layer; forming a conductive contact layer; patterning the conductive contact layer to form a plurality of conductive contact structures, where each of the conductive contact structures is in contact with the first sub-semiconductor pillar or the second sub-semiconductor pillar; and filling an isolation material in a gap between the conductive contact structures to form a third isolation layer.

## Description

### CROSS-REFERENCE

The present application refers to Chinese Patent Application No. 202310420143.7 entitled "SEMICONDUCTOR STRUCTURE AND METHOD FOR MANUFACTURING SAME" and filed on April 14, 2023, the content of which is incorporated herein by reference in its entirety.

### TECHNICAL FIELD

The present disclosure relates to the field of integrated circuit manufacturing, and in particular, to a semiconductor structure and a method for manufacturing the same.

### BACKGROUND

A dynamic random access memory (DRAM) is a volatile memory, and is composed of a plurality of memory cells. Each memory cell mainly includes a transistor and a capacitor, and a source of the transistor is connected to the capacitor through a storage node contact (NC) structure and a landing pad (LP). The memory cells are electrically connected to each other through word lines (WLs) and bit lines (BLs).

In order to improve the integration of the DRAM, a 4F2 (where "F" represents a minimum feature size) architecture scheme has been provided, which uses a vertical gate-all-around (GAA) transistor structure as an access transistor of the DRAM. In the DRAM, vertically extending active pillars are formed on a substrate, surrounding gates are formed on outer sides of the active pillars, and buried bit lines and buried word lines are formed, such that a higher density efficiency can be achieved in principle. However, in the existing 4F2 storage architecture, the area of the storage node contact structure is small, resulting in problems such as alignment difficulty and low alignment accuracy when the capacitor is formed.

Therefore, there is an urgent need for a new semiconductor structure and a method for manufacturing the same to overcome the above problems.

### SUMMARY

Embodiments of the present disclosure intend to provide a semiconductor structure and a method for manufacturing the same, which can reduce the process difficulty.

In order to solve the above problems, an embodiment of the present disclosure provides a method for manufacturing a semiconductor structure. The method includes:
forming an initial structure on a substrate, where the initial structure includes a plurality of main semiconductor pillars arranged in an array along a first direction and a second direction, the main semiconductor pillars extend along a third direction, each of the main semiconductor pillars includes a first sub-semiconductor pillar and a second sub-semiconductor pillar spaced apart from each other along the first direction, a first isolation layer is provided between two of the main semiconductor pillars adjacent to each other in the first direction, a second isolation layer is provided between the first sub-semiconductor pillar and the second sub-semiconductor pillar, the first isolation layer and the second isolation layer both extend along the second direction, the first isolation layer and the second isolation layer both protrude from the first sub-semiconductor pillar and the second sub-semiconductor pillar in the third direction, a first sacrificial pattern is provided on the first sub-semiconductor pillar and the second sub-semiconductor pillar in the third direction, and the first sacrificial pattern is located between the first isolation layer and the second isolation layer in the first direction;
etching the first sacrificial pattern to expose the first sub-semiconductor pillar and the second sub-semiconductor pillar, where an etching rate of an etching material on the first sacrificial pattern is greater than an etching rate of the etching material on the first isolation layer and the second isolation layer;
forming a conductive contact layer, where the conductive contact layer is filled between the first isolation layer and the second isolation layer and covers the first sub-semiconductor pillar and the second sub-semiconductor pillar, and the conductive contact layer extends along the second direction; patterning the conductive contact layer to form a plurality of independent conductive contact structures, where each of the conductive contact structures is in contact with the first sub-semiconductor pillar or the second sub-semiconductor pillar; and
filling an isolation material in a gap between the conductive contact structures to form a third isolation layer.

An embodiment of the present disclosure further provides a semiconductor structure. The semiconductor structure includes:
a substrate;
a plurality of main semiconductor pillars arranged in an array on the substrate along a first direction and a second direction, where the main semiconductor pillars extend along a third direction, and each of the main semiconductor pillars includes a first sub-semiconductor pillar and a second sub-semiconductor pillar spaced apart from each other along the first direction;
a first isolation layer provided between two of the main semiconductor pillars adjacent to each other in the first direction, where the first isolation layer extends along the second direction, and the first isolation layer protrudes from the first sub-semiconductor pillar and the second sub-semiconductor pillar in the third direction;
a second isolation layer provided between the first sub-semiconductor pillar and the second sub-semiconductor pillar, where the second isolation layer extends along the second direction, and the second isolation layer protrudes from the first sub-semiconductor pillar and the second sub-semiconductor pillar in the third direction;
a plurality of independent conductive contact structures provided on the first sub-semiconductor pillar or the second sub-semiconductor pillar, where each of the conductive contact structures is in contact with a top surface and a part of a side surface of the first sub-semiconductor pillar or the second sub-semiconductor pillar, and the conductive contact structure is located between the first isolation layer and the second isolation layer in the first direction; and
a third isolation layer provided between the conductive contact structures in the second direction.

In the method for manufacturing a semiconductor structure provided by the embodiment of the present disclosure, the first isolation layer and the second isolation layer serve as limiting layers, the first sacrificial pattern is removed by self-alignment based on the characteristic that the etching rate of the etching material on the first sacrificial pattern is greater than the etching rate of the etching material on the first isolation layer and the second isolation layer, such that a gap is formed between the first isolation layer and the second isolation layer; then, the conductive contact layer is formed in the gap, and the conductive contact layer is patterned to form the conductive contact structure, which eliminates a need for forming a conductive contact hole separately and forming the conductive contact structure in the conductive contact hole, thereby avoiding problems of alignment difficulty and low alignment accuracy when the conductive contact hole is formed, and greatly reducing the process difficulty.

In the semiconductor structure provided by the embodiment of the present disclosure, the conductive contact structure is in contact with the top surface and a part of the side surface of the first sub-semiconductor pillar or the second sub-semiconductor pillar, such that the contact area between the conductive contact structure and the first sub-semiconductor pillar and the second sub-semiconductor pillar is increased, thereby reducing the contact resistance between the conductive contact structure and the first sub-semiconductor pillar and the second sub-semiconductor pillar.

### BRIEF DESCRIPTION OF THE DRAWINGS

FIG. 1 is a schematic diagram illustrating steps of a method for manufacturing a semiconductor structure according to an embodiment of the present disclosure; and
FIG. 2A to FIG. 2N are process flowcharts of a method for manufacturing a semiconductor structure according to an embodiment of the present disclosure.

### DETAILED DESCRIPTION

Specific embodiments of the semiconductor structure and the method for manufacturing the same provided by the present disclosure are described in detail below with reference to the accompanying drawings.

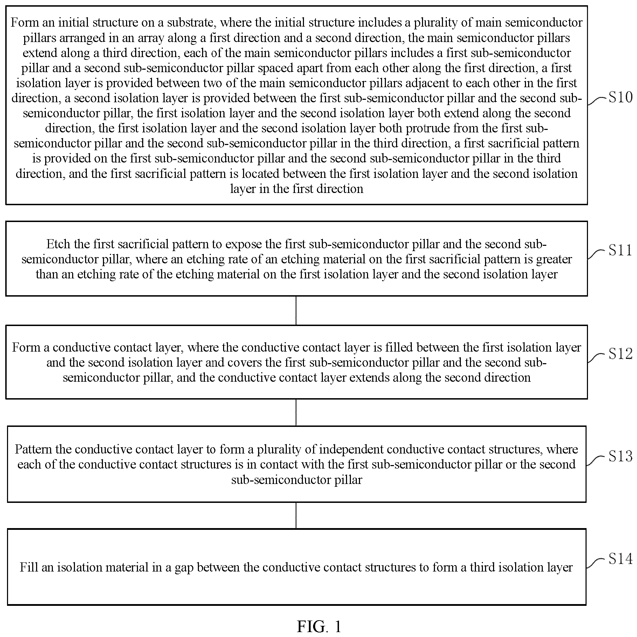

FIG. 1 is a schematic diagram illustrating steps of a method for manufacturing a semiconductor structure according to an embodiment of the present disclosure. Referring to FIG. 1, the method includes the following steps. In step S10, an initial structure 21 is formed on a substrate 20, where the initial structure 21 includes a plurality of main semiconductor pillars 210 arranged in an array along a first direction D1 and a second direction D2, the main semiconductor pillars 210 extend along a third direction D3, each of the main semiconductor pillars 210 includes a first sub-semiconductor pillar 211 and a second sub-semiconductor pillar 212 spaced apart from each other along the first direction D1, a first isolation layer 213 is provided between two of the main semiconductor pillars 210 adjacent to each other in the first direction D1, a second isolation layer 214 is provided between the first sub-semiconductor pillar 211 and the second sub-semiconductor pillar 212, the first isolation layer 213 and the second isolation layer 214 both extend along the second direction D2, the first isolation layer 213 and the second isolation layer 214 both protrude from the first sub-semiconductor pillar 211 and the second sub-semiconductor pillar 212 in the third direction D3, a first sacrificial pattern 313 is provided on the first sub-semiconductor pillar 211 and the second sub-semiconductor pillar 212 in the third direction D3, and the first sacrificial pattern 313 is located between the first isolation layer 213 and the second isolation layer 214 in the first direction D1. In step S11, the first sacrificial pattern 313 is etched to expose the first sub-semiconductor pillar 211 and the second sub-semiconductor pillar 212, where an etching rate of an etching material on the first sacrificial pattern 313 is greater than an etching rate of the etching material on the first isolation layer 213 and the second isolation layer 214. In step S12, a conductive contact layer 700 is formed, where the conductive contact layer 700 is filled between the first isolation layer 213 and the second isolation layer 214 and covers the first sub-semiconductor pillar 211 and the second sub-semiconductor pillar 212, and the conductive contact layer 700 extends along the second direction D2. In step S13, the conductive contact layer 700 is patterned to form a plurality of independent conductive contact structures 720, where each of the conductive contact structures 720 is in contact with the first sub-semiconductor pillar 211 or the second sub-semiconductor pillar 212. In step S14, an isolation material is filled in a gap between the conductive contact structures 720 to form a third isolation layer 730.

In the method for manufacturing a semiconductor structure provided by the embodiment of the present disclosure, the first isolation layer 213 and the second isolation layer 214 serve as limiting layers, the first sacrificial pattern 313 is removed by self-alignment based on the characteristic that the etching rate of the etching material on the first sacrificial pattern 313 is greater than the etching rate of the etching material on the first isolation layer 213 and the second isolation layer 214, such that a gap is formed between the first isolation layer 213 and the second isolation layer 214;then, the conductive contact layer 700 is formed in the gap, and the conductive contact layer 700 is patterned to form the conductive contact structure 720, which eliminates a need for forming a conductive contact hole separately and forming the conductive contact structure 720 in the conductive contact hole, thereby avoiding problems of alignment difficulty and low alignment accuracy when the conductive contact hole is formed, and greatly reducing the process difficulty. In addition, the contact area between the conductive contact structure 720 and the first sub-semiconductor pillar 211 and the second sub-semiconductor pillar 212 is increased, thereby reducing the contact resistance between the conductive contact structure 720 and the first sub-semiconductor pillar 211 and the second sub-semiconductor pillar 212.

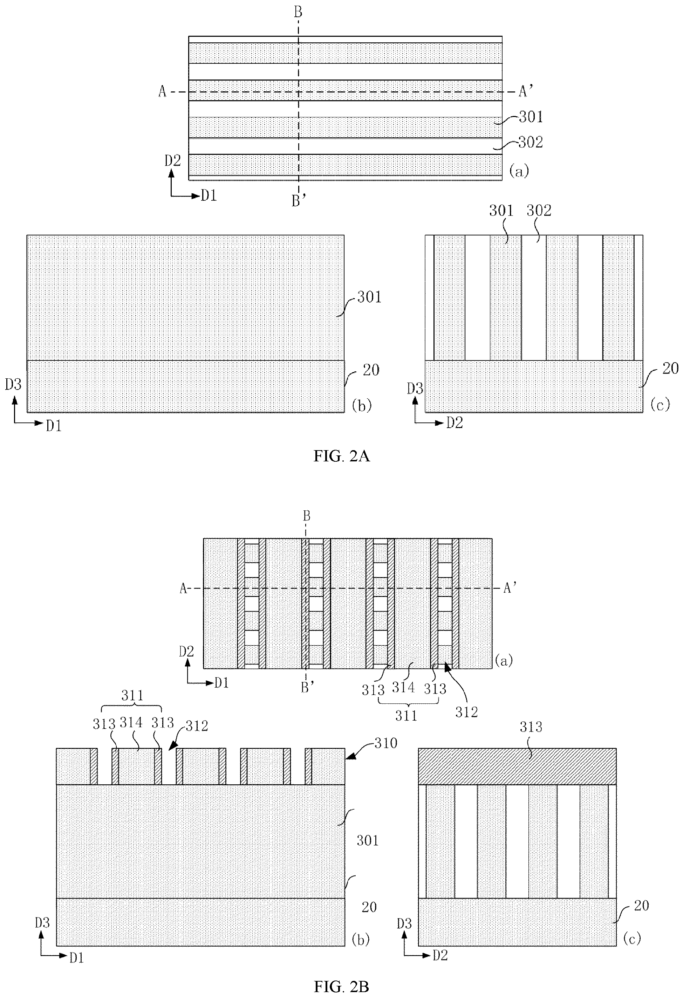

FIG. 2A to FIG. 2N are process flowcharts of a method for manufacturing a semiconductor structure according to an embodiment of the present disclosure. In this embodiment, the first direction D1, the second direction D2, and the third direction D3 are exemplified as X, Y, and Z directions in a Cartesian coordinate system, respectively.

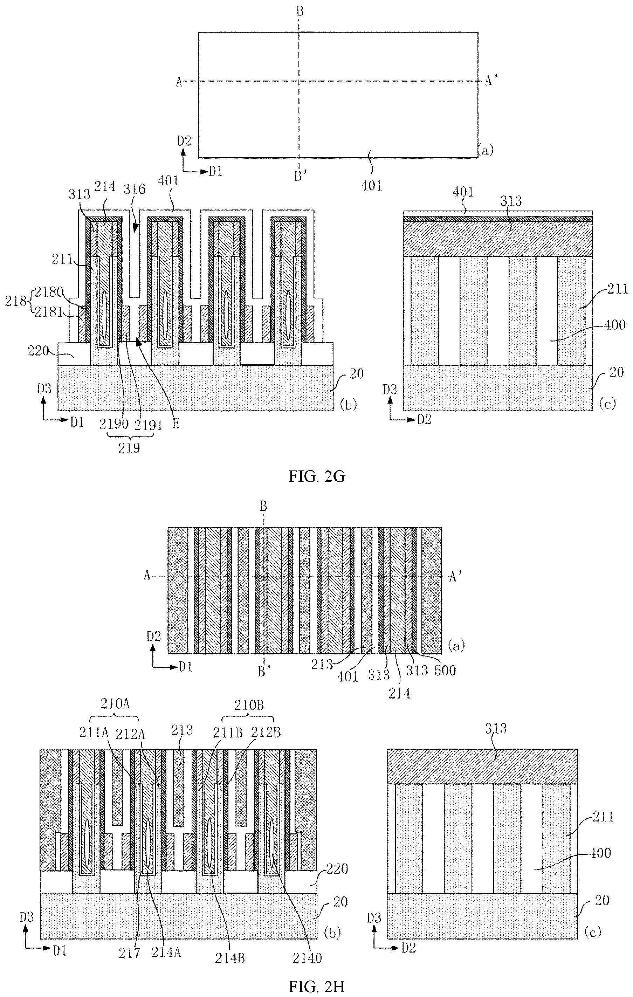

Referring to FIG. 1 and FIG. 2H where (a) is a top view, (b) is a sectional view along line AA' in (a), and (c) is a sectional view along line BB' in (a), in step S10, an initial structure 21 is formed on a substrate 20, where the initial structure 21 includes a plurality of main semiconductor pillars 210 arranged in an array along a first direction D1 and a second direction D2, the main semiconductor pillars 210 extend along a third direction D3, each of the main semiconductor pillars 210 includes a first sub-semiconductor pillar 211 and a second sub-semiconductor pillar 212 spaced apart from each other along the first direction D1, a first isolation layer 213 is provided between two of the main semiconductor pillars 210 adjacent to each other in the first direction D1, a second isolation layer 214 is provided between the first sub-semiconductor pillar 211 and the second sub-semiconductor pillar 212, the first isolation layer 213 and the second isolation layer 214 both extend along the second direction D2, the first isolation layer 213 and the second isolation layer 214 both protrude from the first sub-semiconductor pillar 211 and the second sub-semiconductor pillar 212 in the third direction D3, a first sacrificial pattern 313 is provided on the first sub-semiconductor pillar 211 and the second sub-semiconductor pillar 212 in the third direction D3, and the first sacrificial pattern 313 is located between the first isolation layer 213 and the second isolation layer 214 in the first direction D1.

For example, in the first direction D1, the main semiconductor pillar 210A is spaced apart from the main semiconductor pillar 210B, and the first isolation layer 213 is provided between the main semiconductor pillar 210A and the main semiconductor pillar 210B. The main semiconductor pillar 210A includes the first sub-semiconductor pillar 211A and the second sub-semiconductor pillar 212A spaced apart from each other along the first direction D1, and the second isolation layer 214A is provided between the first sub-semiconductor pillar 211A and the second sub-semiconductor pillar 212A. The main semiconductor pillar 210B includes the first sub-semiconductor pillar 211B and the second sub-semiconductor pillar 212B spaced apart from each other along the first direction D1, and the second isolation layer 214B is provided between the first sub-semiconductor pillar 211B and the second sub-semiconductor pillar 212B. In the third direction D3, the first sacrificial pattern 313 is provided on the first sub-semiconductor pillar 211A, the second sub-semiconductor pillar 212A, the first sub-semiconductor pillar 211B, and the second sub-semiconductor pillar 212B, and in the first direction D1, the first sacrificial pattern 313 is located between the first isolation layer 213 and the second isolation layer 214A and between the first isolation layer 213 and the second isolation layer 214B.

In some embodiments, in the first direction D1, a fourth isolation material layer 401 is further provided between the first isolation layer 213 and the main semiconductor pillar 210 for forming a fourth isolation layer 215 in a subsequent process, the fourth isolation material layer 401 extends along the second direction D2, and surfaces of the first isolation layer 213 and the second isolation layer 214 are flush with a surface of the fourth isolation material layer 401 in the third direction D3. An etching rate of an etching material on the fourth isolation material layer is greater than an etching rate of the etching material on the first isolation layer and the second isolation layer.

In some embodiments, a fifth isolation material layer 400 is further provided between the main semiconductor pillars 210 adjacent to each other in the second direction D2, a surface of the fifth isolation material layer 400 is flush with surfaces of the first sub-semiconductor pillar 211 and the second sub-semiconductor pillar 212 in the third direction D3, and the first sacrificial pattern 313 further covers the surface of the fifth isolation material layer 400.

In some embodiments, the initial structure 21 further includes a sixth isolation layer 217, where the sixth isolation layer 217 is provided between the first sub-semiconductor pillar 211 and the second isolation layer 214 and between the second sub-semiconductor pillar 212 and the second isolation layer 214 so as to further prevent particles in the main semiconductor pillar 210 from diffusing into the second isolation layer 214 and to improve adhesion of the second isolation layer 214 to the main semiconductor pillar 210. For example, the sixth isolation layer 217 is provided between the first sub-semiconductor pillar 211A of the main semiconductor pillar 210A and the second isolation layer 214A, and between the second sub-semiconductor pillar 212A of the main semiconductor pillar 210A and the second isolation layer 214A.

In some embodiments, an air gap 2140 is formed in the second isolation layer 214. The air gap 2140 may be an air gap 2140 naturally formed when the second isolation layer 214 is formed, so as to reduce parasitic capacitance between the first sub-semiconductor pillar 211 and the second sub-semiconductor pillar 212. In other embodiments, the second isolation layer 214 may not be provided with the air gap 2140, but directly filled completely with an isolation material.

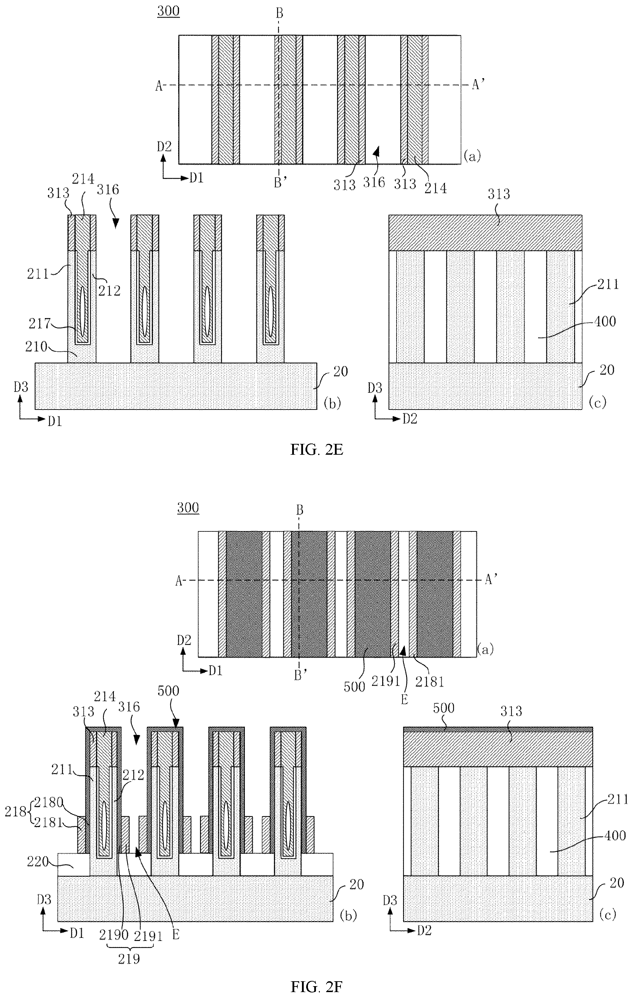

In some embodiments, a first gate structure 218 (labeled in FIG. 2F) and a second gate structure 219 (labeled in FIG. 2F) are further provided on two side surfaces of each of the main semiconductor pillars along the first direction D1, the first gate structure 218 and the second gate structure 219 extend along the second direction D2, the first gate structure 218 is in contact with the first sub-semiconductor pillar 211, and the second gate structure 219 is in contact with the second sub-semiconductor pillar 212.

In some embodiments, bit line structures (not shown) are further provided in the substrate 20, the bit line structures extend along the first direction D1, the bit line structures are spaced apart from each other along the second direction D2, and the bit line structures are connected to a bottom part of the main semiconductor pillar in the third direction D3. In some embodiments, in order to isolate the bit line structures from the first gate structure 218 and the second gate structure 219, the initial structure 21 further includes a seventh isolation layer 220, the seventh isolation layer 220 is provided between the main semiconductor pillars 210 in the first direction D1, the first sub-semiconductor pillar 211 and the second sub-semiconductor pillar 212 protrude from the seventh isolation layer 220 in the third direction D3, and the first gate structure 218 and the second gate structure 219 are provided on the seventh isolation layer 220.

In some embodiments, a top surface of the first sacrificial pattern 313 is flush with top surfaces of the first isolation layer 213 and the second isolation layer 214 in the third direction D3.

As an example, an embodiment of the present disclosure further provides a method for forming the initial structure 21. The method includes the following steps.

Referring to FIG. 2A to FIG. 2E, a first structure 300 is provided, where the first structure 300 includes the plurality of the main semiconductor pillars, a third trench 316 is formed between the main semiconductor pillars 210 adjacent to each other in the first direction D1, the third trench 316 extends along the second direction D2, each of the main semiconductor pillars 210 includes the first sub-semiconductor pillar 211 and the second sub-semiconductor pillar 212 spaced apart from each other along the first direction D1, the second isolation layer 214 is provided between the first sub-semiconductor pillar 211 and the second sub-semiconductor pillar 212, the first sacrificial pattern 313 is provided on the first sub-semiconductor pillar 211 and the second sub-semiconductor pillar 212 in the third direction D3, and a surface of the first sacrificial pattern 313 is flush with the surface of the second isolation layer 214.

In some embodiments, in the first structure 300, the fifth isolation material layer 400 is further provided between the main semiconductor pillars 210 adjacent to each other in the second direction D2, the surface of the fifth isolation material layer 400 is flush with the surfaces of the first sub-semiconductor pillar 211 and the second sub-semiconductor pillar 212 in the third direction D3, and the first sacrificial pattern 313 further covers the surface of the fifth isolation material layer 400.

As an example, a method for forming the first structure 300 includes the following steps.

Referring to FIG. 2A where (a) is a top view, (b) is a sectional view along line AA' in (a), and (c) is a sectional view along line BB' in (a), a substrate 20 is provided, where the substrate 20 is provided with semiconductor layers 301 spaced apart from each other along the second direction D2 and extending along the first direction D1, and an initial isolation material layer 302 is provided between the semiconductor layers 301 adjacent to each other.

The substrate 20 may include a silicon substrate, a germanium (Ge) substrate, a silicon germanium (SiGe) substrate, a silicon-on-insulator (SOI) substrate, a germanium-on-insulator (GOI) substrate, and the like. The substrate 20 may also be a substrate including other element semiconductors or compound semiconductors, such as gallium arsenide, indium phosphide, or silicon carbide. The substrate 20 may also be a laminated structure, such as a silicon/germanium-silicon laminate. In addition, the substrate 20 may be an ion-doped substrate, which may be P-doped or N-doped. A plurality of peripheral devices, such as field effect transistors, capacitors, inductors, and/or diodes, may also be formed in the substrate 20. In this embodiment, the substrate 20 is a silicon substrate, and other device structures, such as a transistor structure or a metal wiring structure, may be included therein, which are not shown as such device structures are irrelevant to the embodiments of the present disclosure.

The initial isolation material layer 302 is configured to insulate the semiconductor layer 301, which may be made of an oxide, such as silicon oxide. In the third direction D3, a surface of the initial isolation material layer 302 is flush with a surface of the semiconductor layer 301.

In this step, a method for forming the semiconductor layer 301 and the initial isolation material layer 302 includes: etching the substrate 20 to form a plurality of trenches extending along the first direction D1, where the plurality of trenches are arranged along the second direction D2; and filling an insulation material in the trenches to form the initial isolation material layers 302, where the substrate 20 between the initial isolation material layers 302 serves as the semiconductor layer 301.

Referring to FIG. 2B where (a) is a top view, (b) is a sectional view along line AA' in (a), and (c) is a sectional view along line BB' in (a), a cap layer 310 is formed, where the cap layer 310 includes a plurality of first patterns 311 extending along the second direction D2, the plurality of the first patterns 311 are spaced apart from each other along the first direction D1, a first trench 312 is formed between the first patterns 311 adjacent to each other in the first direction D1, and the first trench 312 exposes parts of the semiconductor layer 301 and the initial isolation material layer 302. The first pattern 311 includes two of the first sacrificial patterns 313 and a second sacrificial pattern 314 provided between the two of the first sacrificial patterns 313 in the first direction D1, and the first sacrificial pattern 313 of the first pattern 311 is exposed at a sidewall of the first trench 312.

In some embodiments, a method for forming the cap layer 310 includes: forming a second sacrificial material layer on surfaces of the semiconductor layer 301 and the initial isolation material layer 302; patterning the second sacrificial material layer to form the second sacrificial patterns 314, where a space is formed between the second sacrificial patterns 314, the space extends along the second direction D2, and the space exposes parts of the semiconductor layer 301 and the initial isolation material layer 302; covering a first sacrificial material layer on a sidewall and a top surface of the second sacrificial pattern 314 and the exposed surfaces of the semiconductor layer 301 and the initial isolation material layer 302; and removing the first sacrificial material layer on the top surface of the second sacrificial pattern 314 and the surfaces of the semiconductor layer 301 and the initial isolation material layer 302, such that a remaining part of the first sacrificial material layer serves as the first sacrificial pattern 313.

In some embodiments, the material of the first sacrificial pattern 313 includes but is not limited to polycrystalline silicon and silicon oxynitride, and an etch selectivity of the material of the second sacrificial pattern 314 to the material of the first sacrificial pattern 313 is high, so as to ensure that the second sacrificial pattern 314 is not damaged when the first sacrificial material layer is removed.

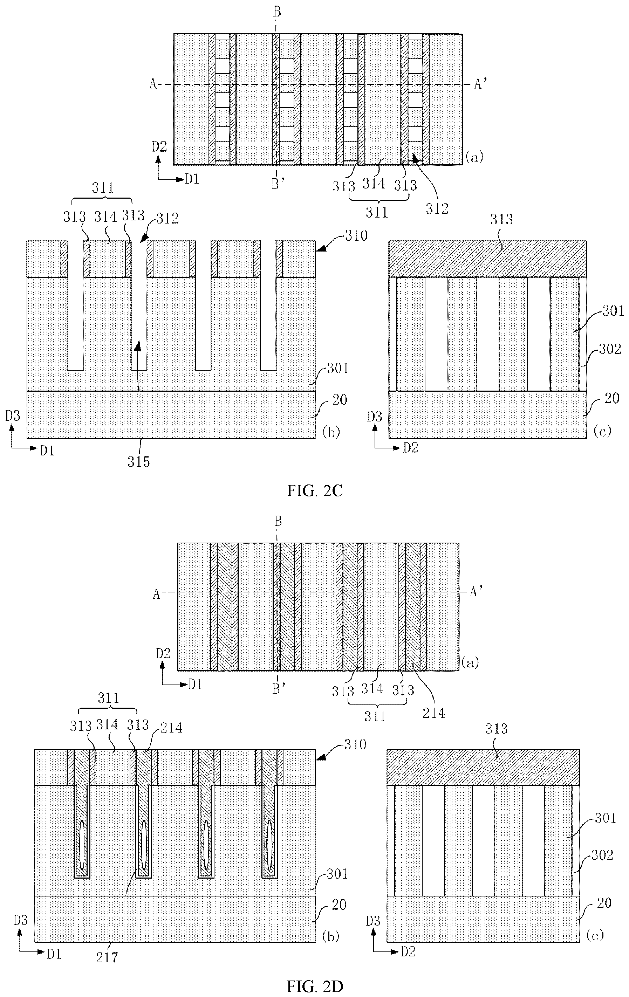

Referring to FIG. 2C where (a) is a top view, (b) is a sectional view along line AA' in (a), and (c) is a sectional view along line BB' in (a), parts of the semiconductor layer 301 and the initial isolation material layer 302 are removed along the first trench 312 with the cap layer 310 as a mask layer 710 so as to form a second trench 315. The second trench 315 extends along the second direction D2, and a plurality of the second trenches 315 are spaced apart from each other along the first direction D1. The semiconductor layer 301 and the initial isolation material layer 302 are exposed at a sidewall of the second trench 315.

Referring to FIG. 2D where (a) is a top view, (b) is a sectional view along line AA' in (a), and (c) is a sectional view along line BB' in (a), an isolation material is filled in the first trench 312 and the second trench 315 to form the second isolation layer 214. The second isolation layer 214 includes but is not limited to a silicon nitride layer. In some embodiments, the surface of the second isolation layer 214 is flush with surfaces of the first sacrificial pattern 313 and the second sacrificial pattern 314 in the third direction D3.

In some embodiments, the isolation material further covers a surface of the cap layer 310, and then this step further includes the step of removing the isolation material on the surface of the cap layer 310 and retaining the isolation material in the first trench 312 and the second trench 315, such that a remaining part of the isolation material serves as the second isolation layer 214.

In some embodiments, before the step of forming the second isolation layer 214, a sixth isolation layer 217 is formed on the sidewall of the second trench 315, where the sixth isolation layer 217 is provided with a gap, and the isolation material is further filled in the gap of the sixth isolation layer 217 when the isolation material is filled in the first trench 312 and the second trench 315.

The sixth isolation layer 217 may be formed only on the surface of the semiconductor layer 301 exposed at the sidewall of the second trench 315, on the surfaces of the semiconductor layer 301 and the initial isolation material layer 302 exposed at the sidewall of the second trench 315, or on the surfaces of the semiconductor layer 301 and the initial isolation material layer 302 exposed at the sidewall of the second trench 315 and on the sidewall of the first trench 312. In this embodiment, an oxide is formed on the surface of the semiconductor layer 301 at the sidewall of the second trench 315 by using a thermal oxidation process, and the oxide serves as the sixth isolation layer 217. The sixth isolation layer 217 is not formed on the surface of the initial isolation material layer 302 exposed at the sidewall of the second trench 315 or on the sidewall of the first trench 312.

In some embodiments, when the isolation material is filled to form the second isolation layer 214, it is difficult to fill the second trench 315 completely with the isolation material due to relatively deep depths and large depth-to-width ratios of the second trench 315 and the first trench 312, such that the air gap 2140 is naturally formed in the second isolation layer 214.

Referring to FIG. 2E where (a) is a top view, (b) is a sectional view along line AA' in (a), and (c) is a sectional view along line BB' in (a), the second sacrificial pattern 314 and parts of the semiconductor layer 301 and the initial isolation material layer 302 below the second sacrificial pattern 314 are removed to form the third trench 316, the main semiconductor pillar, and the fifth isolation material layer 400, where in the third direction D3, an extension depth of the third trench 316 in the substrate 20 is greater than or equal to an extension depth of the second trench 315 in the substrate 20.

In this step, the second sacrificial pattern 314 is removed, the first sacrificial pattern 313 is retained, and surfaces of parts of the semiconductor layer 301 and the initial isolation material layer 302 are exposed. The semiconductor layer 301 and the initial isolation material layer 302 are removed with the first sacrificial pattern 313 as a mask so as to form the third trench 316.

The third trench 316 separates the semiconductor layer 301 into a plurality of main semiconductor pillars 210, and each of the main semiconductor pillars 210 is separated into the first sub-semiconductor pillar 211 and the second sub-semiconductor pillar 212 by the second isolation layer 214 and the sixth isolation layer 217. The third trench 316 further cuts off the initial isolation material layer 302 to form the fifth isolation material layer 400, and the fifth isolation material layer 400 is provided between the main semiconductor pillars 210 adjacent to each other in the second direction D2.

In this embodiment, in the third direction D3, the extension depth of the third trench 316 in the substrate 20 is greater than the extension depth of the second trench 315 in the substrate 20. That is, a bottom part of the main semiconductor pillar 210 is not separated by the second trench 315 in the third direction D3, and the main semiconductor pillar 210 has an integral bottom part. An upper part of the main semiconductor pillar 210 is separated by the second trench 315 into the first sub-semiconductor pillar 211 and the second sub-semiconductor pillar 212. In other embodiments, in the third direction D3, the extension depth of the third trench 316 in the substrate 20 may be equal to the extension depth of the second trench 315 in the substrate 20. That is, the main semiconductor pillar 210 is completely separated into the first sub-semiconductor pillar 211 and the second sub-semiconductor pillar 212.

At this point, the first structure 300 is formed by the above steps.

Referring to FIG. 2F where (a) is a top view, (b) is a sectional view along line AA' in (a), and (c) is a sectional view along line BB' in (a), before the step of depositing an isolation material in the third trench 316 to form the fourth isolation material layer 401, the following step is performed.

The seventh isolation layer 220 is formed at a bottom part of the third trench 316, where a surface of the seventh isolation layer 220 protrudes from a bottom surface of the second trench 315 in the third direction D3. The seventh isolation layer 220 serves as an insulating layer between the subsequently formed first gate structure 218 and second gate structure 219 and the substrate 20 or the bit line structure in the substrate 20. The seventh isolation layer 220 includes but is not limited to an oxide layer or a nitride layer.

After the seventh isolation layer 220 is formed, the first gate structure 218 and the second gate structure 219 are formed in the third trench 316, where a space E is formed between the first gate structure 218 and the second gate structure 219 in the same third trench 316 in the first direction D1, such that the first gate structure 218 and the second gate structure 219 in the same third trench 316 are insulated from each other. The first gate structure 218 includes a gate dielectric layer 2180 and a conductive layer 2181, and the gate dielectric layer 2180 is located between the first sub-semiconductor pillar 211 and the conductive layer 2181. The second gate structure 219 includes a gate dielectric layer 2190 and a conductive layer 2191, and the gate dielectric layer 2190 is located between the first sub-semiconductor pillar 212 and the conductive layer 2191. A region of the first sub-semiconductor pillar 211 corresponding to the conductive layer 2181 serves as a channel region of a transistor, and a region of the second sub-semiconductor pillar 212 corresponding to the conductive layer 2191 serves as a channel region of another transistor.

In some embodiments, the gate dielectric layer 2180 and the gate dielectric layer 2190 are the same gate dielectric material layer 500, where a region of the gate dielectric material layer 500 covered by the conductive layer 2181 serves as the gate dielectric layer 2180, and a region of the gate dielectric material layer 500 covered by the conductive layer 2191 serves as the gate dielectric layer 2190. In this step, the gate dielectric material layer 500 covers not only the surface of the main semiconductor pillar exposed at a sidewall of the third trench 316, but also the surface of the fifth isolation material layer 400 exposed at the sidewall of the third trench 316, a side surface and the top surface of the first sacrificial pattern 313, and a top surface of the second isolation layer 214.

In some embodiments, a method for forming the first gate structure 218 and the second gate structure 219 includes: forming the gate dielectric material layer 500 at least in the third trench 316; filling a gate material in the third trench 316; and removing a part of the gate material, such that a remaining part of the gate material serves as the conductive layer 2181 and the conductive layer 2191.

In the third direction D3, the surfaces of the first sub-semiconductor pillar 211 and the second sub-semiconductor pillar 212 protrude from the first gate structure 218 and the second gate structure 219 so as to form a buried gate.

Referring to FIG. 2G where (a) is a top view, (b) is a sectional view along line AA' in (a), and (c) is a sectional view along line BB' in (a), the isolation material is deposited in the third trench 316 to form the fourth isolation material layer 401, where the fourth isolation material layer 401 covers a side surface of the main semiconductor pillar 210 and the side surface of the first sacrificial pattern 313. In this step, the third trench 316 is not filled completely with the fourth isolation material layer 401, and the fourth isolation material layer 401 includes but is not limited to an oxide layer.

In some embodiments, the fourth isolation material layer 401 further covers a side surface of the fifth isolation material layer 400. The fourth isolation material layer 401 is further filled in the space between the first gate structure 218 and the second gate structure 219 in the same third trench 316, such that the first gate structure 218 and the second gate structure 219 in the same third trench 316 are insulated from each other. In some embodiments, if a gate dielectric layer is provided on the side surface of the main semiconductor pillar 210 and the side surface of the first sacrificial pattern 313, the fourth isolation material layer 401 covers a surface of the gate dielectric layer.

Referring to FIG. 2H where (a) is a top view, (b) is a sectional view along line AA' in (a), and (c) is a sectional view along line BB' in (a), the isolation material is filled completely in the third trench 316 to form the first isolation layer 213. The surface of the first isolation layer 213 is flush with the surface of the second isolation layer 214 in the third direction D3.

In some embodiments, the isolation material not only fills the third trench 316 completely, but also covers a top surface of the semiconductor structure, and then in this step, the isolation material on the top surface of the semiconductor structure is further removed, such that only the isolation material in the third trench 316 is retained. If the top surface of the semiconductor structure is further provided with the fourth isolation material layer 401 and the gate dielectric material layer 500, in this step, such layers on the top surface of the semiconductor structure are removed together, such that the surface of the first isolation layer 213, the surface of the second isolation layer 214, the surface of the first sacrificial pattern 313, the surface of the fourth isolation material layer 401, and a surface of the gate dielectric material layer 500 are flush in the third direction D3. In some embodiments, a method for removing the first isolation layer 213, the surface of the fourth isolation material layer 401, and the gate dielectric material layer 500 on a top part of the semiconductor structure may be chemical mechanical polishing.

At this point, the initial structure 21 is formed by the above steps.

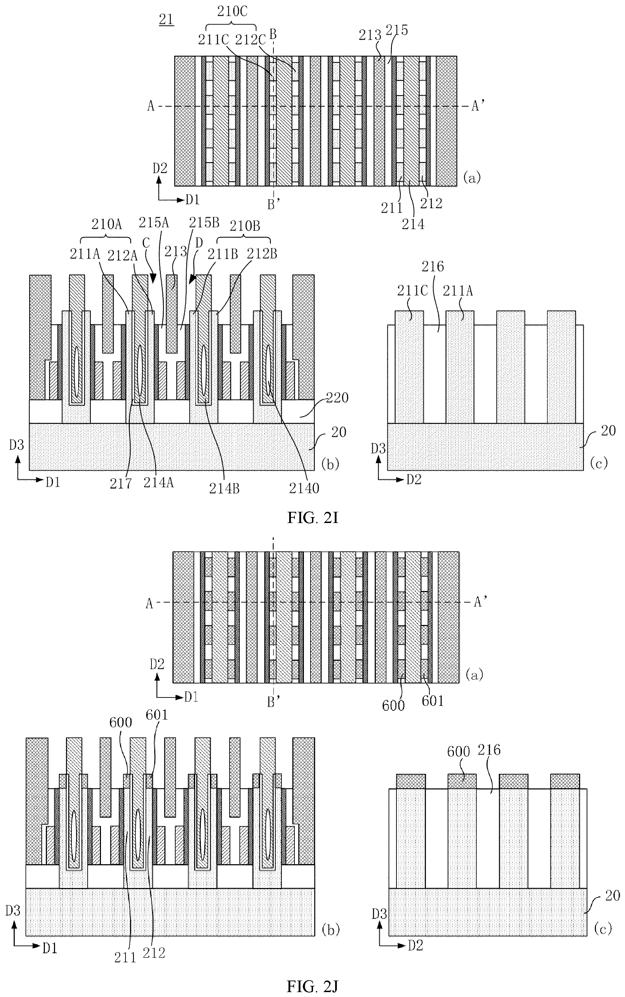

Referring to FIG. 1 and FIG. 2I where (a) is a top view, (b) is a sectional view along line AA' in (a), and (c) is a sectional view along line BB' in (a), in step S11, the first sacrificial pattern 313 is etched to expose the first sub-semiconductor pillar 211 and the second sub-semiconductor pillar 212, where an etching rate of an etching material on the first sacrificial pattern 313 is greater than an etching rate of the etching material on the first isolation layer 213 and the second isolation layer 214. In this step, after the first sacrificial pattern 313 is removed, the surfaces of the first sub-semiconductor pillar 211 and the second sub-semiconductor pillar 212 are exposed, and the first isolation layer 213 and the second isolation layer 214 both protrude from the first sub-semiconductor pillar 211 and the second sub-semiconductor pillar 212 in the third direction D3.

In this embodiment, the first sacrificial pattern 313 serves as a placeholder, and the first sub-semiconductor pillar 211 and the second sub-semiconductor pillar 212 are exposed after the first sacrificial pattern 313 is removed, such that it is possible to avoid manufacturing small-sized contact holes corresponding to the first sub-semiconductor pillar 211 and the second sub-semiconductor pillar 212 for exposing the first sub-semiconductor pillar 211 and the second sub-semiconductor pillar 212, which reduces the process difficulty and improves the alignment accuracy of the subsequent conductive contact structure 720 with the first sub-semiconductor pillar 211 and the second sub-semiconductor pillar 212, thereby further improving the reliability of the semiconductor structure.

In this step, the first sacrificial pattern 313 is selectively removed based on the characteristic that the etching rate of the etching material on the first sacrificial pattern 313 is greater than the etching rate of the etching material on the first isolation layer 213 and the second isolation layer 214, such that the first isolation layer 213 and the second isolation layer 214 are retained to form a gap between the first isolation layer 213 and the second isolation layer 214. The gap extends along the second direction D2, and the first sub-semiconductor pillar 211 and the second sub-semiconductor pillar 212 are separately located in different gaps.

For example, the second isolation layer 214A, the first isolation layer 213, and the second isolation layer 214B are spaced apart from each other. A gap C is formed between the second isolation layer 214A and the first isolation layer 213, and a gap D is formed between the first isolation layer 213 and the second isolation layer 214B. The second sub-semiconductor pillar 212A is located in the gap C, and the first sub-semiconductor pillar 211B is located in the gap D.

In some embodiments, in this step, a part of the fourth isolation material layer 401 is selectively removed based on the characteristic that the etching rate of the etching material on the fourth isolation material layer 401 is greater than the etching rate of the etching material on the first isolation layer 213 and the second isolation layer 214, such that a remaining part of the fourth isolation material layer 401 serves as the fourth isolation layer 215. The fourth isolation layer 215 extends along the second direction D2, and the surfaces of the first sub-semiconductor pillar 211 and the second sub-semiconductor pillar 212 are flush with a surface of the fourth isolation layer 215 or protrude from the surface of the fourth isolation layer 215 in the third direction D3.

For example, the fourth isolation layer 215A is further provided between the first isolation layer 213 and the main semiconductor pillar 210A, and the fourth isolation layer 215B is further provided between the first isolation layer 213 and the main semiconductor pillar 210B. In the third direction D3, the surface of the second sub-semiconductor pillar 212A protrudes from the surface of the fourth isolation layer 215A, and the surface of the first sub-semiconductor pillar 211B protrudes from the surface of the fourth isolation layer 215B, so as to increase the exposed surface areas of the second sub-semiconductor pillar 212A and the first sub-semiconductor pillar 211B, thereby increasing the contact area between the second sub-semiconductor pillar 212A and the first sub-semiconductor pillar 211B and the conductive contact structure 720. In other embodiments, the surface of the second sub-semiconductor pillar 212A may be flush with the surface of the fourth isolation layer 215A, and the surface of the first sub-semiconductor pillar 211B may be flush with the surface of the fourth isolation layer 215B.

In some embodiments, a gap is formed between the gate structures of the main semiconductor pillars 210 adjacent to each other, and the fourth isolation layer 215 covers the gate structures and fills the gap between the gate structures completely, such that the gate structures of the main semiconductor pillars 210 adjacent to each other are insulated from each other.

For example, the second gate structure 219 is provided on a side of the main semiconductor pillar 210A facing the main semiconductor pillar 210B, and the first gate structure 218 is provided on a side of the main semiconductor pillar 210B facing the main semiconductor pillar 210A. The second gate structure 219 is provided adjacent to the first gate structure 218 with a gap E therebetween. The fourth isolation layer 215 covers the second gate structure 219 and the first gate structure 218 and fills the gap E therebetween completely, such that the second gate structure 219 provided on the side of the main semiconductor pillar 210A facing the main semiconductor pillar 210B and the first gate structure 218 provided on the side of the main semiconductor pillar 210B facing the main semiconductor pillar 210A are insulated from each other.

In some embodiments, in this step, a part of the fifth isolation material layer 400 is selectively removed based on the characteristic that an etching rate of the etching material on the fifth isolation material layer 400 is greater than the etching rate of the etching material on the first isolation layer 213 and the second isolation layer 214, such that a remaining part of the fifth isolation material layer 400 serves as the fifth isolation layer 216. The first sub-semiconductor pillar 211 and the second sub-semiconductor pillar 212 protrude from the fifth isolation layer 216 in the third direction D3.

For example, in the second direction D2, the main semiconductor pillar 210A is spaced apart from the main semiconductor pillar 210C, and the fifth isolation layer 216 is provided between the main semiconductor pillar 210A and the main semiconductor pillar 210C. That is, the fifth isolation layer 216 is provided between the first sub-semiconductor pillar 211A of the main semiconductor pillar 210A and the first sub-semiconductor pillar 211C of the main semiconductor pillar 210C, and between the second sub-semiconductor pillar 212A of the main semiconductor pillar 210A and the second sub-semiconductor pillar 212C of the main semiconductor pillar 210C. The first sub-semiconductor pillar 211A, the second sub-semiconductor pillar 212A, the first sub-semiconductor pillar 211C, and the second sub-semiconductor pillar 212C all protrude from the fifth isolation layer 216.

In some embodiments, in this step, the gate dielectric layer is selectively removed based on the characteristic that an etching rate of the etching material on the gate dielectric layer is greater than the etching rate of the etching material on the first isolation layer 213 and the second isolation layer 214, until the surface of the gate dielectric layer is flush with the surface of the fourth isolation layer 215 in the third direction D3.

In some embodiments, the material of the first isolation layer 213 is selected such that etch selectivities of the first sacrificial pattern 313, the fourth isolation material layer 401, and the fifth isolation material layer 400 to the first isolation layer 213 are high, such that selective etching can be achieved in a semiconductor process. For example, in some embodiments, the first sacrificial pattern 313 is a polycrystalline silicon layer, the fourth isolation material layer 401 and the fifth isolation material layer 400 are silicon oxide layers, and the first isolation layer 213 is a nitride layer, such that selective removal of the first sacrificial pattern 313, the fourth isolation material layer 401, and the fifth isolation material layer 400 can be achieved by selecting an etching solution with a higher etching rate for the silicon oxide layer and the polycrystalline silicon layer and a lower etching rate for the silicon nitride layer in the semiconductor process.

In some embodiments, the method for manufacturing a semiconductor structure further includes the following steps. Referring to FIG. 2J where (a) is a top view, (b) is a sectional view along line AA' in (a), and (c) is a sectional view along line BB' in (a), the first sub-semiconductor pillar 211 and the second sub-semiconductor pillar 212 are metallized to form a first metal silicide layer 600 on the surface of the first sub-semiconductor pillar 211 and form a second metal silicide layer 601 on the surface of the second sub-semiconductor pillar 212. A method for metallizing the first sub-semiconductor pillar 211 and the second sub-semiconductor pillar 212 includes: filling a metal, such as cobalt, between the first isolation layer 213 and the second isolation layer 214, such that the metal covers the exposed surfaces of the first sub-semiconductor pillar 211 and the second sub-semiconductor pillar 212; and performing a heat treatment to combine the metal with the first sub-semiconductor pillar 211 and the second sub-semiconductor pillar 212 so as to form a metal silicide, such as cobalt silicide.

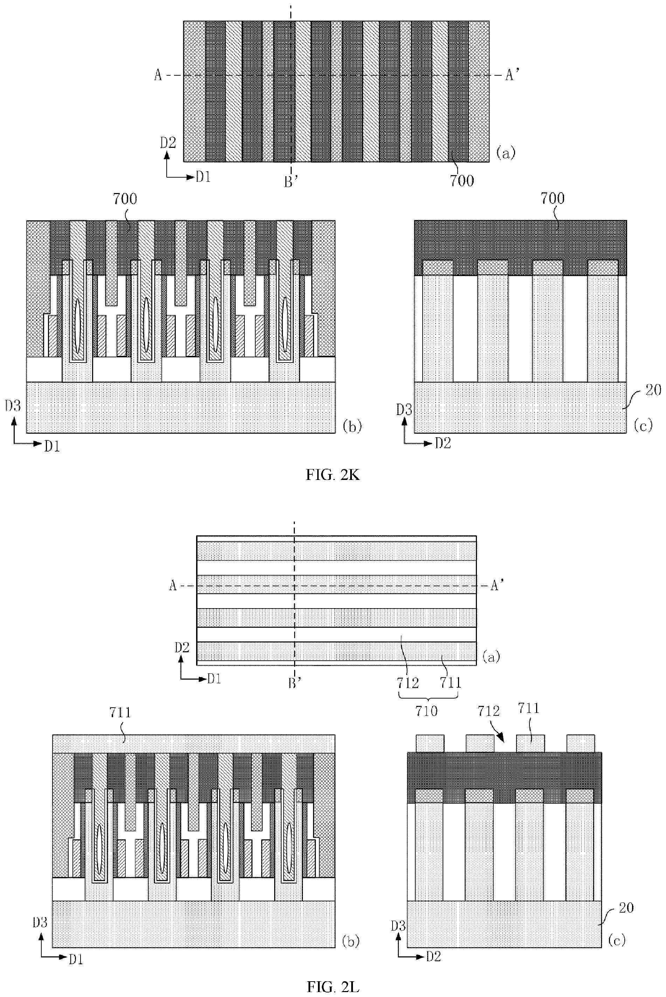

Referring to FIG. 1 and FIG. 2K where (a) is a top view, (b) is a sectional view along line AA' in (a), and (c) is a sectional view along line BB' in (a), in step S12, a conductive contact layer 700 is formed, where the conductive contact layer 700 is filled between the first isolation layer 213 and the second isolation layer 214 and covers the first sub-semiconductor pillar 211 and the second sub-semiconductor pillar 212, and the conductive contact layer 700 extends along the second direction D2.

In some embodiments, the conductive contact layer 700 is a multi-layer composite structure. For example, in this embodiment, the conductive contact layer 700 is a composite structure of a titanium layer, a titanium nitride layer, and a tungsten layer, where the thicknesses of the titanium layer and the titanium nitride layer are less than the thickness of the tungsten layer.

In some embodiments, in the first direction D1, the fourth isolation layer 215 is further provided between the first isolation layer 213 and the second isolation layer 214 in addition to the first sub-semiconductor pillar 211 or the second sub-semiconductor pillar 212 provided therebetween, and the conductive contact layer 700 further covers the fourth isolation layer 215, such that the width of the gap between the first isolation layer 213 and the second isolation layer 214 in the second direction D2 is further increased, which reduces a depth-to-width ratio of the gap between the first isolation layer 213 and the second isolation layer 214, and improves the film quality of the conductive contact layer 700.

As an example, an embodiment of the present disclosure further provides a method for forming the conductive contact layer 700. The method includes the following steps. A titanium material layer is deposited, such that the titanium material layer covers the exposed surface of the semiconductor structure, such as the surfaces of the first isolation layer 213, the second isolation layer 214, the first sub-semiconductor pillar 211, the second sub-semiconductor pillar 212, the fourth isolation layer 215, the fifth isolation layer 216, and the gate dielectric material layer 500. A titanium nitride material layer is deposited on the titanium material layer, such that the titanium nitride material layer covers the titanium material layer and does not fill the gap between the first isolation layer 213 and the second isolation layer 214 completely. A tungsten layer is formed on the titanium nitride material layer, such that the tungsten layer fills the gap between the first isolation layer 213 and the second isolation layer 214 completely and covers the top surface of the semiconductor structure. The tungsten layer, the titanium nitride layer, and the titanium layer on the top surface of the semiconductor structure are removed, and the tungsten layer, the titanium nitride layer, and the titanium layer between the first isolation layer 213 and the second isolation layer 214 are retained to form the conductive contact layer 700.

In some embodiments, the conductive contact layer 700 is in contact with the first metal silicide layer 600 and the second metal silicide layer 601.

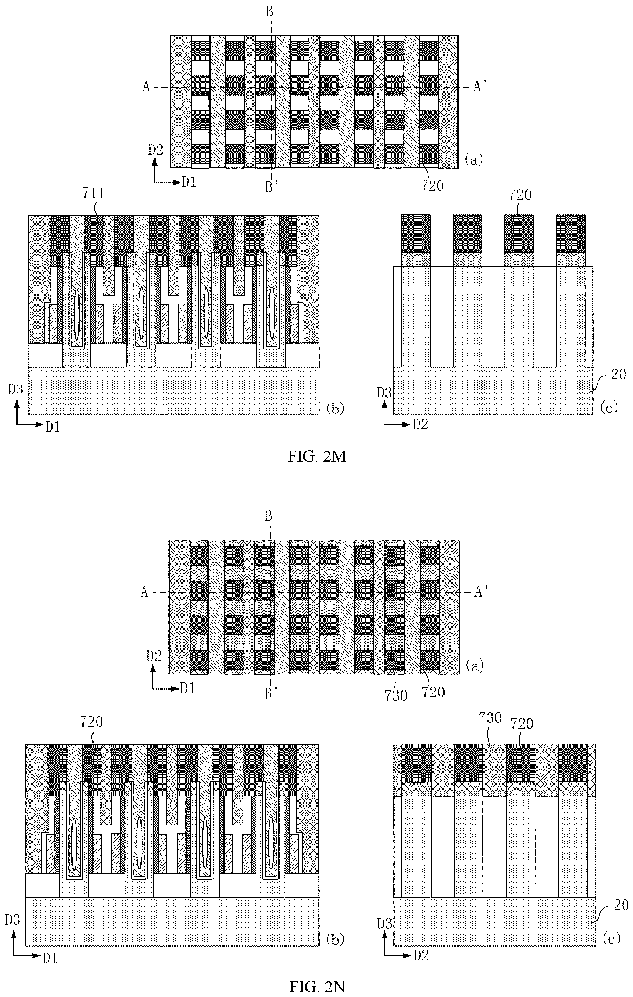

Referring to FIG. 1 and FIG. 2M where (a) is a top view, (b) is a sectional view along line AA' in (a), and (c) is a sectional view along line BB' in (a), in step S13, the conductive contact layer 700 is patterned to form a plurality of independent conductive contact structures 720, where each of the conductive contact structures 720 is in contact with the first sub-semiconductor pillar 211 or the second sub-semiconductor pillar 212.

In this step, a part of the conductive contact layer 700 is removed to form the plurality of conductive contact structures 720, and the arrangement of the conductive contact structures 720 is the same as that of the first sub-semiconductor pillars 211 and the second sub-semiconductor pillars 212, where one first sub-semiconductor pillar 211 is connected to one conductive contact structure 720, and one second sub-semiconductor pillar 212 is connected to one conductive contact structure 720.

In some embodiments, the conductive contact structure 720 is not only in contact with a top surface of the first sub-semiconductor pillar 211 or the second sub-semiconductor pillar 212, but also in contact with a part of a side surface of the first sub-semiconductor pillar 211 or the second sub-semiconductor pillar 212, such that the contact area is greatly increased, thereby reducing the contact resistance between the first sub-semiconductor pillar 211 or the second sub-semiconductor pillar 212 and the conductive contact structure 720.

As an example, an embodiment of the present disclosure further provides a method for patterning the conductive contact layer 700. The method includes the following steps.

Referring to FIG. 2L where (a) is a top view, (b) is a sectional view along line AA' in (a), and (c) is a sectional view along line BB' in (a), a patterned mask layer 710 is formed on the conductive contact layer 700, where the mask layer 710 includes a plurality of second patterns 711 extending along the first direction D1, the plurality of the second patterns 711 are spaced apart from each other along the second direction D2, a fourth trench 712 is formed between the second patterns 711 adjacent to each other, and the fourth trench 712 exposes a part of the conductive contact layer 700. In some embodiments, the first direction D1 is an extension direction of the bit line structure.

Referring to FIG. 2M, a part of the conductive contact layer 700 is removed along the fourth trench 712 with the mask layer 710 as a mask so as to form the conductive contact structure 720. The mask layer 710 is removed after the conductive contact structure 720 is formed. In some embodiments, a side surface of the conductive contact structure 720 is flush with the side surface of the first sub-semiconductor pillar 211 or the second sub-semiconductor pillar 212 in the second direction D2.

Referring to FIG. 1 and FIG. 2N where (a) is a top view, (b) is a sectional view along line AA' in (a), and (c) is a sectional view along line BB' in (a), in step S14, an isolation material is filled in a gap between the conductive contact structures 720 to form a third isolation layer 730.

The third isolation layer 730 is filled in the gap between the conductive contact structures 720 adjacent to each other, such that the conductive contact structures 720 adjacent to each other are insulated from each other. In some embodiments, the material of the third isolation layer 730 is the same as the material of the first isolation layer 213 and the second isolation layer 214, e.g., all being silicon nitride. In some embodiments, a surface of the third isolation layer 730 is flush with a surface of the conductive contact structure 720 in the third direction D3.

The method for manufacturing a semiconductor structure provided by the embodiment of the present disclosure eliminates a need for forming a conductive contact hole separately and forming the conductive contact structure 720 in the conductive contact hole, thereby avoiding problems of alignment difficulty and low alignment accuracy when the conductive contact hole is formed, and greatly reducing the process difficulty. In addition, the contact area between the conductive contact structure 720 and the first sub-semiconductor pillar 211 and the second sub-semiconductor pillar 212 is increased, thereby reducing the contact resistance between the conductive contact structure 720 and the first sub-semiconductor pillar 211 and the second sub-semiconductor pillar 212.

After the third isolation layer 730 is formed, the method for manufacturing a semiconductor structure further includes a step of forming a charge storage structure, which is in contact connection to the conductive contact structure 720. As the method for manufacturing a semiconductor structure provided by the embodiment of the present disclosure forms a flat surface of the conductive contact structure 720, a flat base substrate can be provided for the subsequently formed charge storage structure, which further avoids electric leakage of the charge storage structure. Moreover, in some embodiments, the exposed surface area of the conductive contact structure 720 is greater than the area of the top surface of the first sub-semiconductor pillar 211 or the second sub-semiconductor pillar 212, which can reduce the difficulty of alignment of the charge storage structure, increase the contact area between the charge storage structure and the conductive contact structure 720, and reduce the contact resistance.

An embodiment of the present disclosure further provides a semiconductor structure manufactured by using the above method for manufacturing a semiconductor structure. Referring to FIG. 2A to FIG. 2N, the semiconductor structure includes: a substrate 20; a plurality of main semiconductor pillars 210 arranged in an array on the substrate 20 along a first direction D1 and a second direction D2, where the main semiconductor pillars 210 extend along a third direction D3, and each of the main semiconductor pillars 210 includes a first sub-semiconductor pillar 211 and a second sub-semiconductor pillar 212 spaced apart from each other along the first direction D1; a first isolation layer 213 provided between two of the main semiconductor pillars 210 adjacent to each other in the first direction D1, where the first isolation layer 213 extends along the second direction D2, and the first isolation layer 213 protrudes from the first sub-semiconductor pillar 211 and the second sub-semiconductor pillar 212 in the third direction D3; a second isolation layer 214 provided between the first sub-semiconductor pillar 211 and the second sub-semiconductor pillar 212, where the second isolation layer 214 extends along the second direction D2, and the second isolation layer 214 protrudes from the first sub-semiconductor pillar 211 and the second sub-semiconductor pillar 212 in the third direction D3; a plurality of independent conductive contact structures 720 provided on the first sub-semiconductor pillar 211 or the second sub-semiconductor pillar 212, where each of the conductive contact structures 720 is in contact with a top surface and a part of a side surface of the first sub-semiconductor pillar 211 or the second sub-semiconductor pillar 212, and the conductive contact structure 720 is located between the first isolation layer 213 and the second isolation layer 214 in the first direction D1; and a third isolation layer 730 provided between the conductive contact structures 720 in the second direction D2.

In the embodiment of the present disclosure, the conductive contact structure 720 can be in contact with the top surface and a part of the side surface of the first sub-semiconductor pillar 211 or the second sub-semiconductor pillar 212, such that the contact area between the conductive contact structure 720 and the first sub-semiconductor pillar 211 or the second sub-semiconductor pillar 212 is increased, and the contact resistance is reduced.

In some embodiments, the semiconductor structure further includes a charge storage structure that is in contact connection to the conductive contact structure 720. The conductive contact structure 720 has a large surface area of a surface used for connecting to the charge storage structure, which can further increase the contact area between the charge storage structure and the conductive contact structure 720 and reduce the contact resistance. Moreover, the surface of the conductive contact structure 720 is flat, such that a flat base substrate can be provided for the charge storage structure, which further avoids electric leakage of the charge storage structure.

In some embodiments, the semiconductor structure further includes a fourth isolation layer 215. The fourth isolation layer 215 is provided between two of the main semiconductor pillars 210 in the first direction D1, the first sub-semiconductor pillar 211 and the second sub-semiconductor pillar 212 protrude from the fourth isolation layer 215 in the third direction D3, and the conductive contact structure 720 further covers the fourth isolation layer 215. In some embodiments, the material of the fourth isolation layer 215 is different from the material of the first isolation layer 213. For example, the material of the fourth isolation layer 215 is silicon oxide, and the material of the first isolation layer 213 is silicon nitride.

In some embodiments, the semiconductor structure further includes a fifth isolation layer 216, and the fifth isolation layer 216 is provided between the main semiconductor pillars 210 in the second direction D2. The first sub-semiconductor pillar 211 and the second sub-semiconductor pillar 212 protrude from the fifth isolation layer 216 in the third direction D3, and the third isolation layer 730 is further provided above the fifth isolation layer 216 and covers the fifth isolation layer 216. The fourth isolation layer 215 further covers a sidewall of the fifth isolation layer 216 in the first direction D1, and a surface of the fourth isolation layer 215 is flush with a surface of the fifth isolation layer 216 in the third direction D3. In some embodiments, the material of the fifth isolation layer 216 is the same as the material of the fourth isolation layer 215, e.g., both being silicon oxide.

In some embodiments, the semiconductor structure further includes a sixth isolation layer 217. The sixth isolation layer 217 is provided between the first sub-semiconductor pillar 211 and the second isolation layer 214 and between the second sub-semiconductor pillar 212 and the second isolation layer 214 in the first direction D1, and functions to prevent particle diffusion and improve adhesion. In some embodiments, the material of the sixth isolation layer 217 is different from the material of the second isolation layer 214. For example, the material of the sixth isolation layer 217 is silicon oxide, and the material of the second isolation layer 214 is silicon nitride.

In some embodiments, in the third direction D3, an extension depth of the first isolation layer 213 in the substrate 20 is greater than or equal to an extension depth of the second isolation layer 214 in the substrate 20. When the extension depth of the first isolation layer 213 in the substrate 20 is greater than the extension depth of the second isolation layer 214 in the substrate 20, a bottom part of the main semiconductor pillar 210 is not separated by the second isolation layer 214, and only a top part of the main semiconductor pillar 210 is separated into the first sub-semiconductor pillar 211 and the second sub-semiconductor pillar 212. In some embodiments, an air gap 2140 is formed in the second isolation layer 214.

In some embodiments, the semiconductor structure further includes: a seventh isolation layer 220, a first gate structure 218, and a second gate structure 219. The seventh isolation layer 220 is provided between the main semiconductor pillars 210 in the first direction D1, and the first sub-semiconductor pillar 211 and the second sub-semiconductor pillar 212 protrude from the seventh isolation layer 220 in the third direction D3. The first gate structure 218 and the second gate structure 219 extend along the second direction D2 and are provided on the seventh isolation layer 220. The first gate structure 218 and the second gate structure 219 are separately located on two side surfaces of each of the main semiconductor pillars 210 along the first direction D1, the first gate structure 218 is in contact with the first sub-semiconductor pillar 211, and the second gate structure 219 is in contact with the second sub-semiconductor pillar 212. A region of the first sub-semiconductor pillar 211 corresponding to the first gate structure 218 serves as a channel region of a transistor, and a region of the second sub-semiconductor pillar 212 corresponding to the second gate structure 219 serves as a channel region of another transistor.

In some embodiments, the semiconductor structure further includes: a first metal silicide layer 600 and a second metal silicide layer 601. The first metal silicide layer 600 is located on a surface of the first sub-semiconductor pillar 211, the second metal silicide layer 601 is located on a surface of the second sub-semiconductor pillar 212, and the conductive contact structure 720 is in contact with the first metal silicide layer 600 or the second metal silicide layer 601. The first metal silicide layer 600 and the second metal silicide layer 601 are configured to reduce the contact resistance between the conductive contact structure 720 and the first sub-semiconductor pillar 211 or the second sub-semiconductor pillar 212, and both of the layers may be cobalt silicide layers.

The semiconductor structure and the method for manufacturing the same provided by the embodiments of the present disclosure are applicable to a dynamic random access memory, including but not limited to a dynamic random access memory with a 4F2 storage architecture.

The foregoing only illustrates preferred embodiments of the present disclosure, and it should be noted that a number of improvements and modifications may be made by those of ordinary skill in the art without departing from the principles of the present disclosure, which shall be considered as falling within the protection scope of the present disclosure.

## Claims

1. A method for manufacturing a semiconductor structure, comprising:
forming an initial structure (21) on a substrate, wherein the initial structure (21) comprises a plurality of main semiconductor pillars (210) arranged in an array along a first direction and a second direction, the plurality of main semiconductor pillars (210) extend along a third direction, each of the plurality of main semiconductor pillars (210) comprises a first sub-semiconductor pillar (211) and a second sub-semiconductor pillar (212) spaced apart from each other along the first direction, a first isolation layer (213) is provided between two of the plurality of main semiconductor pillars (210) adjacent to each other in the first direction, a second isolation layer (214) is provided between the first sub-semiconductor pillar (211) and the second sub-semiconductor pillar (212), the first isolation layer (213) and the second isolation layer (214) both extend along the second direction, the first isolation layer (213) and the second isolation layer (214) both protrude from the first sub-semiconductor pillar (211) and the second sub-semiconductor pillar (212) in the third direction, a first sacrificial pattern (313) is provided on the first sub-semiconductor pillar (211) and the second sub-semiconductor pillar (212) in the third direction, and the first sacrificial pattern (313) is located between the first isolation layer (213) and the second isolation layer (214) in the first direction;
etching the first sacrificial pattern (313) to expose the first sub-semiconductor pillar (211) and the second sub-semiconductor pillar (212), wherein an etching rate of an etching material on the first sacrificial pattern (313) is greater than an etching rate of the etching material on the first isolation layer (213) and the second isolation layer (214);
forming a conductive contact layer (700), wherein the conductive contact layer (700) is filled between the first isolation layer (213) and the second isolation layer (214) and covers the first sub-semiconductor pillar (211) and the second sub-semiconductor pillar (212), and the conductive contact layer (700) extends along the second direction;
patterning the conductive contact layer (700) to form a plurality of independent conductive contact structures (720), wherein each of the plurality of conductive contact structures (720) is in contact with the first sub-semiconductor pillar (211) or the second sub-semiconductor pillar (212); and
filling an isolation material in a gap between the plurality of conductive contact structures (720) to form a third isolation layer (730).

2. The method for manufacturing a semiconductor structure according to claim 1, wherein a fourth isolation layer (215) is further provided between the first isolation layer (213) and one of the plurality of main semiconductor pillars (210) in the first direction, the fourth isolation layer (215) extends along the second direction, surfaces of the first sub-semiconductor pillar (211) and the second sub-semiconductor pillar (212) are flush with a surface of the fourth isolation layer (215) or protrude from the surface of the fourth isolation layer (215) in the third direction, each one of the plurality of conductive contact structures (720) further covers the fourth isolation layer (215), and each one of the plurality of conductive contact structures (720) is in contact with a top surface or with the top surface and a part of a side surface of the first sub-semiconductor pillar (211) or the second sub-semiconductor pillar (212); and
the step of forming the initial structure (21) further comprises:
providing a first structure (300), wherein the first structure (300) comprises the plurality of the main semiconductor pillars (210), a third trench (316) is formed between two of the plurality of main semiconductor pillars (210) adjacent to each other in the first direction, the third trench (316) extends along the second direction, each of the plurality of main semiconductor pillars (210) comprises the first sub-semiconductor pillar (211) and the second sub-semiconductor pillar (212) spaced apart from each other along the first direction, the second isolation layer (214) is provided between the first sub-semiconductor pillar (211) and the second sub-semiconductor pillar (212), and the first sacrificial pattern (313) is provided on the first sub-semiconductor pillar (211) and the second sub-semiconductor pillar (212) in the third direction;
depositing an isolation material in the third trench (316) to form a fourth isolation material layer (401), wherein the fourth isolation material layer (401) covers a side surface of one of the plurality of main semiconductor pillars (210) and a side surface of the first sacrificial pattern (313);
filling an isolation material completely in the third trench (316) to form the first isolation layer (213); and
removing a part of the fourth isolation material layer (401) in the step of etching the first sacrificial pattern (313), such that a remaining part of the fourth isolation material layer (401) serves as the fourth isolation layer (215), wherein an etching rate of the etching material on the fourth isolation material layer (401) is greater than the etching rate of the etching material on the first isolation layer (213) and the second isolation layer (214).

3. The method for manufacturing a semiconductor structure according to claim 2, wherein a fifth isolation layer (216) is further provided between two of the plurality of main semiconductor pillars (210) adjacent to each other in the second direction, and the fifth isolation layer (216) protrudes from the first sub-semiconductor pillar (211) and the second sub-semiconductor pillar (212) in the third direction; and the step of forming the initial structure (21) further comprises:
further providing a fifth isolation material layer (400) between two of the plurality of main semiconductor pillars (210) adjacent to each other in the second direction in the first structure (300), wherein a surface of the fifth isolation material layer (400) is flush with the surfaces of the first sub-semiconductor pillar (211) and the second sub-semiconductor pillar (212) in the third direction, and the first sacrificial pattern (313) further covers the surface of the fifth isolation material layer (400);
further covering a side surface of the fifth isolation material layer (400) by the fourth isolation material layer (401) in the step of forming the fourth isolation material layer (401); and
further removing a part of the fifth isolation material layer (400) in the step of removing the first sacrificial pattern (313), such that a remaining part of the fifth isolation material layer (400) serves as the fifth isolation layer (216).

4. The method for manufacturing a semiconductor structure according to claim 3, wherein the step of forming the first structure (300) comprises:
providing a substrate (20), wherein the substrate (20) is provided with semiconductor layers (301) spaced apart from each other along the second direction and extending along the first direction, and an initial isolation material layer (302) is provided between the semiconductor layers (301) adjacent to each other;
forming a cap layer (310), wherein the cap layer (310) comprises a plurality of first patterns (311) extending along the second direction, the plurality of the first patterns (311) are spaced apart from each other along the first direction, a first trench (312) is formed between two of the plurality of first patterns (311) adjacent to each other in the first direction, the first trench (312) exposes parts of the semiconductor layer (301) and the initial isolation material layer (302), and each one of the plurality of first patterns (311) comprises two of the first sacrificial patterns (313) and a second sacrificial pattern (314) provided between the two of the first sacrificial patterns (313) in the first direction;
removing parts of the semiconductor layer (301) and the initial isolation material layer (302) along the first trench (312) with the cap layer (310) as a mask layer so as to form a second trench (315);
filling an isolation material in the first trench (312) and the second trench (315) to form the second isolation layer (214); and
removing the second sacrificial pattern (314) and parts of the semiconductor layer (301) and the initial isolation material layer (302) below the second sacrificial pattern (314) to form the third trench (316), one of the plurality of main semiconductor pillars (210), and the fifth isolation material layer (400), wherein in the third direction, an extension depth of the third trench (316) in the substrate (20) is greater than or equal to an extension depth of the second trench (315) in the substrate (20).

5. The method for manufacturing a semiconductor structure according to claim 4, wherein before the step of filling the isolation material in the first trench (312) and the second trench (315) to form the second isolation layer (214), the method comprises:
forming a sixth isolation layer (217) at a sidewall of the second trench (315), wherein the sixth isolation layer (217) is provided with a gap; and
further filling the isolation material in the gap of the sixth isolation layer (217) in the step of filling the isolation material in the first trench (312) and the second trench (315) to form the second isolation layer (214).

6. The method for manufacturing a semiconductor structure according to claim 5, wherein an air gap (2140) is formed in the second isolation layer (214) in the step of filling the isolation material in the gap of the sixth isolation layer (217).

7. The method for manufacturing a semiconductor structure according to claim 2, wherein a first gate structure (218) and a second gate structure (219) are further provided on two side surfaces of each of the plurality of main semiconductor pillars (210) along the first direction, the first gate structure (218) and the second gate structure (219) extend along the second direction, the first gate structure (218) is in contact with the first sub-semiconductor pillar (211), and the second gate structure (219) is in contact with the second sub-semiconductor pillar (212); and the step of forming the initial structure (21) further comprises:
forming a seventh isolation layer (220) at a bottom part of the third trench (316) before forming the fourth isolation material layer (401), wherein a surface of the seventh isolation layer (220) protrudes from a bottom surface of the second trench (315) in the third direction;
forming the first gate structure (218) and the second gate structure (219) in the third trench (316), wherein a space is formed between the first gate structure (218) and the second gate structure (219) in the same third trench (316) in the first direction; and
further filling the fourth isolation material layer (401) in the space in the step of forming the fourth isolation material layer (401).

8. The method for manufacturing a semiconductor structure according to any one of claims 1 to 7, wherein the step of patterning the conductive contact layer (700) further comprises:
forming a patterned mask layer (710) on the conductive contact layer (700), wherein the mask layer (710) comprises a plurality of second patterns (711) extending along the first direction, the plurality of the second patterns (711) are spaced apart from each other along the second direction, a fourth trench (712) is formed between two of the plurality of second patterns (711) adjacent to each other, and the fourth trench (712) exposes a part of the conductive contact layer (700); and removing a part of the conductive contact layer (700) along the fourth trench (712) with the mask layer (710) as a mask so as to form one of the plurality of conductive contact structures (720).

9. The method for manufacturing a semiconductor structure according to any one of claims 1 to 7, wherein before the step of forming the conductive contact layer (700), the method further comprises:
metallizing the first sub-semiconductor pillar (211) and the second sub-semiconductor pillar (212) to form a first metal silicide layer (600) on the surface of the first sub-semiconductor pillar (211) and form a second metal silicide layer (601) on the surface of the second sub-semiconductor pillar (212); and
contacting each one of the plurality of conductive contact structures (720) with the first metal silicide layer (600) or the second metal silicide layer (601) in the step of patterning the conductive contact layer (700) to form the plurality of independent conductive contact structures (720).

10. A semiconductor structure, comprising:
a substrate (20);
a plurality of main semiconductor pillars (210) arranged in an array on the substrate (20) along a first direction and a second direction, wherein the plurality of main semiconductor pillars (210) extend along a third direction, and each of the plurality of main semiconductor pillars (210) comprises a first sub-semiconductor pillar (211) and a second sub-semiconductor pillar (212) spaced apart from each other along the first direction;
a first isolation layer (213) provided between two of the plurality of main semiconductor pillars (210) adjacent to each other in the first direction, wherein the first isolation layer (213) extends along the second direction, and the first isolation layer (213) protrudes from the first sub-semiconductor pillar (211) and the second sub-semiconductor pillar (212) in the third direction; a second isolation layer (214) provided between the first sub-semiconductor pillar (211) and the second sub-semiconductor pillar (212), wherein the second isolation layer (214) extends along the second direction, and the second isolation layer (214) protrudes from the first sub-semiconductor pillar (211) and the second sub-semiconductor pillar (212) in the third direction; a plurality of independent conductive contact structures (720) provided on the first sub-semiconductor pillar (211) or the second sub-semiconductor pillar (212), wherein each of the plurality of conductive contact structures (720) is in contact with a top surface and a part of a side surface of the first sub-semiconductor pillar (211) or the second sub-semiconductor pillar (212), and each one of the plurality of conductive contact structures (720) is located between the first isolation layer (213) and the second isolation layer (214) in the first direction; and
a third isolation layer (730) provided between the plurality of conductive contact structures (720) in the second direction.

11. The semiconductor structure according to claim 10, further comprising:
a fourth isolation layer (215) provided between two of the plurality of main semiconductor pillars (210) in the first direction, wherein the first sub-semiconductor pillar (211) and the second sub-semiconductor pillar (212) protrude from the fourth isolation layer (215) in the third direction, and each one of the plurality of conductive contact structures (720) further covers the fourth isolation layer (215);
a fifth isolation layer (216) provided between the plurality of main semiconductor pillars (210) in the second direction, wherein the first sub-semiconductor pillar (211) and the second sub-semiconductor pillar (212) protrude from the fifth isolation layer (216) in the third direction, and the third isolation layer (730) further covers the fifth isolation layer (216); and
a sixth isolation layer (217) provided between the first sub-semiconductor pillar (211) and the second isolation layer (214) and between the second sub-semiconductor pillar (212) and the second isolation layer (214) in the first direction.

12. The semiconductor structure according to claim 10 or 11, wherein in the third direction, an extension depth of the first isolation layer (213) in the substrate (20) is greater than or equal to an extension depth of the second isolation layer (214) in the substrate (20).

13. The semiconductor structure according to any one of claims 10 to 12, wherein an air gap (2140) is formed in the second isolation layer (214).

14. The semiconductor structure according to any one of claims 10 to 13, further comprising:
a seventh isolation layer (220) provided between the plurality of main semiconductor pillars (210) in the first direction, wherein the first sub-semiconductor pillar (211) and the second sub-semiconductor pillar (212) protrude from the seventh isolation layer (220) in the third direction; and
a first gate structure (218) and a second gate structure (219) provided on the seventh isolation layer (220) and extending along the second direction, wherein the first gate structure (218) and the second gate structure (219) are separately located on two side surfaces of each of the plurality of main semiconductor pillars (210) along the first direction, the first gate structure (218) is in contact with the first sub-semiconductor pillar (211), and the second gate structure (219) is in contact with the second sub-semiconductor pillar (212).

15. The semiconductor structure according to any one of claims 10 to 14, further comprising:
a first metal silicide layer (600) located on a surface of the first sub-semiconductor pillar (211); and
a second metal silicide layer (601) located on a surface of the second sub-semiconductor pillar (212), wherein
each one of the plurality of conductive contact structures (720) is in contact with the first metal silicide layer (600) or the second metal silicide layer (601).
